(19) Europäisches Patentamt
European Patent Office
Office européen des brevets

(11) **EP 0 986 173 B1**

(12) **EUROPÄISCHE PATENTSCHRIFT**

(45) Veröffentlichungstag und Bekanntmachung des Hinweises auf die Patenterteilung:
**04.03.2009 Patentblatt 2009/10**

(51) Int Cl.:
***H03K 4/06*** *(2006.01)*     ***H03K 6/04*** *(2006.01)*

(21) Anmeldenummer: **99117882.3**

(22) Anmeldetag: **10.09.1999**

(54) **Schaltungsanordnung zur Flankensteilheitsformung**

Circuit device to control the steepness of an edge

Circuit pour la mise en forme de la raideur d'une pente

(84) Benannte Vertragsstaaten:
**FR GB IT**

(30) Priorität: **11.09.1998 DE 19841719**

(43) Veröffentlichungstag der Anmeldung:
**15.03.2000 Patentblatt 2000/11**

(73) Patentinhaber: **STMicroelectronics GmbH**
**85630 Grasbrunn (DE)**

(72) Erfinder: **Heinrich, Peter**
**83024 Rosenheim (DE)**

(74) Vertreter: **Hirsch, Peter**
**Klunker Schmitt-Nilson Hirsch**
**Patentanwälte**
**Destouchesstrasse 68**
**80796 München (DE)**

(56) Entgegenhaltungen:
**US-A- 3 889 159**     **US-A- 3 903 735**
**US-A- 4 651 032**     **US-A- 4 746 842**
**US-A- 4 945 292**     **US-A- 5 502 410**
**US-A- 5 519 338**

**Beschreibung**

Die Erfindung betrifft eine elektrische Schaltungsanordnung zur Formung der Flankensteilheit einer an einem Ausgangsanschluß auftretenden impulsförmigen Ausgangsspannung und zur Erkennung eines Kurzschlusses an dem Ausgangsanschluß.

Herkömmlicherweise weist eine derartige Schaltungsanordnung einen Regelkreis mit einem Operationsverstärker auf, dessen invertierender Eingang über einen Kondensator mit dem Ausgangsanschluß, dessen nicht invertierender Eingang mit einer Referenzstromquelle und dessen Ausgang mit dem Steuereingang eines Transistors verbunden ist. Der Ausgangsanschluß ist über einen Widerstand mit einem ersten Versorgungsspannungsanschluß, der normalerweise ein positives Potential aufweist, und über den Transistor mit einem zweiten Versorgungsspannungsanschluß, der üblicherweise Massepotential hat, verbunden.

Der Kondensator liefert an den invertierenden Eingang des Operationsverstärkers einen Kondensatorstrom

$$Ic = C \cdot dU/dt, \tag{1}$$

wobei C die Kapazität des Kondensators, U der Spannungsabfall über dem Widerstand und t die Zeit sind. Bei konstanter Spannung, also außerhalb der Flanken eines impulsförmigen Signals, ist der Kondensatorstrom Ic = 0, während er während des Vorliegens von Impulsflanken von 0 verschieden ist. Der Operationsverstärker regelt den Kondensatorstrom auf den Wert des Referenzstroms, was einer ganz bestimmten Steilheit des Spannungsabfalls am Widerstand entspricht.

Eine Flankensteilheitsregelung führt man beispielsweise durch, um die mit steilen Impulsflanken verbundenen, hochfrequenten elektromagnetischen Störstrahlungen zu reduzieren.

An den Ausgangsanschluß der Regelschaltung kann beispielsweise eine Busleitung angeschlossen sein, beispielsweise eine der beiden Doppelleitungen eines CAN-Bussystems, wie man es heutzutage in Kraftfahrzeugen verwendet. Dabei steht die Abkürzung CAN für Controlled Area Network. Beispielsweise bei solchen Bussystemen kann es vorkommen, daß die an den Ausgangsanschluß der Regelschaltung angeschlossene Busleitung an irgendeiner Stelle einen Kurzschluß zum positiven Versorgungsspannungsanschluß aufweist. In diesem Fall wird der Widerstand zwischen dem Ausgangsanschluß der Regelschaltung und diesem positiven Versorgungsspannungsanschluß kurzgeschlossen. Da ein solcher Kurzschluß zu einem konstanten Potentialwert am Ausgangsanschluß der Regelschaltung führt, wird der Kondensatorstrom zu Null und versucht die Regelschaltung, den Transistor auf maximale Stromabgabe zu steuern, um den Kondensatorstrom wieder auf den Stromwert der Referenzstromquelle zu bringen. Den Problemen, die ein solcher Kurzschluß mit sich bringt, nämlich hoher Stromverbrauch und hohe Verlustleistung, kann man dadurch begegnen, daß man eine Kurzschlußschutzschaltung vorsieht, welche dann, wenn der Transistorstrom einen bestimmten Schutzschwellenwert überschritten hat, ein Abschalten der Regelschaltung bewirkt.

Wenn mit einer solchen Schutzschaltung auch ein Schutz vor länger andauernden Kurzschlüssen geschaffen ist, bleiben jedoch ernsthafte Probleme bestehen. Die am Ausgangsanschluß der Regelschaltung wirkende Last ist praktisch immer induktiv, mindestens aufgrund dessen, daß eine an diesen Ausgangsanschluß angeschlossene Leitung eine Leitungsinduktivität aufweist. Ein hoher Kurzschlußstrom vor dem Zeitpunkt der Schutzabschaltung hat zur Folge, daß sich in der Lastinduktivität entsprechend hohe magnetische Energie sammelt, die zum Zeitpunkt der Schutzabschaltung zu induktiven Spannungsimpulsen führt, die relativ hohe Spannungswerte annehmen können. Solche Spannungsimpulse resultieren einerseits in relativ hoher elektromagnetischer Störabstrahlung und bringen andererseits die Gefahr mit sich, daß an die Leitung angeschlossene Signaldecoder in Form von Komparatoren solche induktiven Spannungsimpulse fälschlicherweise als Signal- oder Datenimpulse interpretieren und es daher zu einer Verfälschung von über die Leitung übertragenen Daten kommt.

Die Patentschrift US-A-3 889 159 offenbart eine Schaltung, wobei ein kurzer Testimpuls an einem Ausgang generiert wird, um einen eventuellen Kurzschluß vor einer längerdauernden Einschaltung der Schaltung zu detektieren. Wenn eine am Ausgang generierte Spannung am Ende des Testimpulses einem Kurzschluß entspricht, wird die längerdauernde Einschaltung unterbunden. Weder eine bestimmte Kurzschluß-Schwelle noch eine Flankensteilheitsregelung wird dabei offenbart.

Die oben erwähnten Probleme lassen sich erfindungsgemäß mit einer elektrischen Schaltungsanordnung überwinden, wie sie im Anspruch 1 angegeben ist und den weiteren Ansprüchen entsprechend ausgestaltet sein kann.

Eine erfindungsgemäße Schaltungsanordnung umfaßt eine umschaltbare Regelschaltung, mittels welcher die Flankensteilheit der Ausgangsspannung in einem ersten Schaltzustand in Abhängigkeit von einem an einem internen Widerstand auftretenden Spannungsverlauf steuerbar und in einem zweiten Schaltzustand in Abhängigkeit von dem Ausgangsspannungsverlauf regelbar ist und die sich in einem dritten Schaltzustand in einem im wesentlichen stromlosen Zustand befindet. Bei dem internen Widerstand handelt es sich dabei um einen anderen Widerstand als den an den Ausgangsanschluß angeschlossenen Widerstand. Der interne Widerstand wird somit durch einen Kurzschluß, welcher den an den Ausgangsanschluß angeschlossenen Widerstand überbrückt, nicht beeinträchtigt.

Außerdem besitzt die erfindungsgemäße Schaltungsanordnung eine Detektorschaltung, die ein Detektionssignal liefen, wenn die Ausgangsspannung um mindestens einen vorbestimmten Wert von dem vor Flankenbeginn auftretenden Ausgangsspannungswert abweicht. Ferner ist eine Timerschaltung vorgesehen, mittels welcher die Regelschaltung eine vorbestimmte Zeitdauer nach Flankenbeginn vom ersten in den zweiten Schaltzustand umgeschaltet wird, wenn zu diesem Zeitpunkt das Detektionssignal vorliegt, und vom ersten in den dritten Schaltzustand umgeschaltet wird, wenn zu diesem Zeitpunkt das Detektionssignal nicht vorliegt.

Mit der erfindungsgemäßen Schaltungsanordnung wird also mit einer Steuerung der Flankensteilheit der am Ausgangsanschluß auftretenden Ausgangsspannung begonnen, wobei diese Steuerung von einem Bauelement, nämlich dem internen Widerstand, geleitet wird, das von einem Kurzschluß am Ausgangsanschluß nicht betroffen ist. Während dieser Phase, in welcher sich die Regelschaltung im ersten Schaltzustand befindet, kann also selbst dann kein höherer Strom fließen, als er der gewünschten Flankensteilheit entspricht, wenn ein Kurzschluß am Ausgangsanschluß der Schaltungsanordnung vorliegt.

Mittels der Detektionsschaltung wird verglichen, ob der momentane Spannungswert der zu regelnden Flanke einen vorbestimmten Mindestabstand von demjenigen Spannungswert aufweist, welcher vor Flankenbeginn vorlag. Ist ein solcher Mindestabstand von dem Spannungswert vor Flankenbeginn gegeben, gibt die Detektionsschaltung ein dies signalisierendes Detektionssignal ab.

Mit Hilfe der Timerschaltung wird ermittelt, ob nach Ablauf einer vorbestimmten Zeitdauer seit Flankenbeginn das Detektionssignal vorliegt, der aktuelle Ausgangsspannungswert also den Mindestabstand von dem vor Flankenbeginn auftretenden Spannungswert erreicht hat. Ist dies der Fall, kann davon ausgegangen werden, daß kein Kurzschluß vorliegt. Hat der aktuelle Spannungswert nach Ablauf dieser Zeitspanne jedoch den Mindestabstand von dem vor Flankenbeginn auftretenden Spannungswert nicht erreicht, wird von dem Vorliegen eines Kurzschlusses ausgegangen.

Dabei wird der Abstand, den die Flanken-Spannung von dem vor Flankenbeginn auftretenden Spannungswert haben muß, um das Detektionssignal zu liefern, so groß gewählt, wie er im Kurzschlußfall nicht erreicht werden kann.

Liegt nach Ablauf der genannten Zeitspanne das Detektionssignal vor und somit kein Kurzschluß, wird die Regelschaltung in den zweiten Schaltzustand umgeschaltet, in welchem von der Flankensteilheitssteuerung in Abhängigkeit von dem Spannungsabfall am internen Widerstand auf die Regelung der Flankensteilheit in Abhängigkeit von der am Ausgangsanschluß auftretenden Spannung umgeschaltet wird.

Liegt das Detektionssignal nach Ablauf der genannten Zeitspanne nicht vor und ist daher von einem Kurzschluß auszugehen, wird die Regelschaltung in den dritten Schaltzustand umgeschaltet, in welchem die Regelschaltung stromlos oder im wesentlichen stromlos geschaltet wird.

Mit der erfindungsgemäßen Schaltungsanordnung wird auf einen Kurzschluß also nicht erst dann reagiert, wenn ein nur im Kurzschlußfall möglicher vorbestimmter Maximalstromwert überschritten ist, sondern das Vorliegen eines Kurzschlusses wird bereits gegen Anfang der jeweiligen Flanke festgestellt, während die Flankensteilheit noch in Abhängigkeit vom internen Widerstand gesteuert wird, ein Kurzschluß am Ausgangsanschluß sich also noch nicht stromerhöhend auswirken kann.

Da mit zunehmendem Durchlaufen der Flanke der am Ausgangsanschluß fließende Strom immer mehr zunimmt, die Stromlosschaltung der Schaltungsanordnung bei dem Erkennen eines Kurzschlusses aber schon im Bereich des Beginns der jeweiligen Flanke erfolgt, zu welcher Zeit der am Ausgangsanschluß fließende Strom noch relativ gering ist, ist zum Zeitpunkt der Umschaltung der Regelschaltung in den dritten Schaltzustand, also zum Zeitpunkt der Stromlosschaltung der Schaltungsanordnung, noch wenig magnetische Energie in der Lastinduktivität gespeichert. Folglich werden höhere induktive Spannungsspitzen beim Stromlosschalten der Schaltungsanordnung und die damit einhergehenden elektromagnetischen Störabstrahlungen und Signalfehlinterpretationen vermieden.

Mit einer erfindungsgemäßen Schaltungsanordnung weist der ab Beginn der Flanke fließende Strom auch im Kurzschlußfall einen langsamen Anstieg auf und werden ein hoher Kurzschlußstrom, eine hohe Verlustleistung, eine hochfrequente elektromagnetische Störabstrahlung und Signalfehlinterpretationen vermieden.

Bei einer bevorzugten Ausführungsform der Erfindung weist die Regelschaltung zwei Regelkreise auf, von denen einer den internen Widerstand und der andere den an den Ausgangsanschluß angeschlossenen Widerstand aufweist, wobei eine erste Umschalteinrichtung vorgesehen ist, mittels welcher eine Umschaltung zwischen erstem und zweitem Schaltzustand, also eine Umschaltung hinsichtlich des jeweils regelaktiven Regelkreises, vorgenommen wird. Außerdem kann eine zweite Umschalteinrichtung vorgesehen werden, mittels welcher beide Regelkreise stromlos oder im wesentlichen stromlos geschaltet werden, wenn ein Kurzschluß erkannt wird.

Beide Regelkreise können nach Art der eingangs erläuterten herkömmlichen Regelschaltung aufgebaut sein, wobei für beide Regelkreise ein gemeinsamer Operationsverstärker mit einer gemeinsamen Referenzstromquelle verwendet wird und nur die beiden Kondensatoren, die beiden Transistoren und die beiden Widerstände verschieden sind. Dabei sind den beiden Kondensatoren je ein Schalter zugeordnet, wobei diese beiden Schalter die erste Umschalteinrichtung bilden.

Bei einer Ausführungsform der Erfindung weist die Detektorschaltung einen Komparator auf, welcher eine Summenspannung aus der momentanen Ausgangsspannung und einer konstanten Offsetspannung mit dem vor Flankenbeginn herrschenden Ausgangsspannungswert vergleicht. Hierfür kann eine Speicherschaltung dienen, in welcher die vor Flankenbeginn herrschende Ausgangsspannung abgetastet und gespeichert worden ist, um für den genannten Vergleich zur Verfügung zu stehen.

Die Timerschaltung umfaßt bei einer Ausführungsform der Erfindung einen Zähler, der bei Flankenbeginn in Zählbetrieb versetzt wird und der beim Erreichen eines vorbestimmten Zählstandes ein Zeitablaufsignal abgibt, durch welches der Ablauf der vorbestimmten Zeitdauer definiert wird, bei welchem überprüft wird, ob der momentane Spannungswert am Ausgangsanschluß der Schaltungsanordnung bereits den Abstand von dem vor Flankenbeginn vorliegenden Spannungswert aufweist, der erreicht sein muß, um davon auszugehen, daß kein Kurzschluß vorhanden ist.

Bei der Ausführungsform der Erfindung mit zwei Regelkreisen kann man den Widerstandswert des internen Widerstandes größer machen als den Widerstandswert des an den Ausgangsanschluß angeschlossenen Widerstandes (der vom Leitungswiderstand der an den Ausgangsanschluß angeschlossenen Leitung abhängt), um den durch den internen Widerstand fließenden Strom gering zu halten, der von dem die Schaltungsanordnung enthaltenden Halbleiterchip geliefert werden muß. Damit die Flankenform während der Phase der Flankensteilheitssteuerung durch den ersten Regelkreis und während der Phase der Flankensteilheitsregelung durch den zweiten Regelkreis mindestens im wesentlichen übereinstimmt, kann man die aktiven Flächen von erstem und zweitem Transistor in etwa proportional zum Widerstandswertverhältnis der genannten Widerstände verschieden machen. Das heißt, dem einen hohen Widerstandswert aufweisenden internen Widerstand des ersten Regelkreises wird ein erster Transistor mit niedrigerer aktiver Transistorfläche zugeordnet, während der Transistor des zweiten Regelkreises eine dem am Ausgangsanschluß wirksamen Widerstand entsprechende kleinere aktive Transistorfläche aufweist.

Die Erfindung sowie weitere Aufgaben, Aspekte und Vorteile der Erfindung werden nun anhand einer Ausführungsform näher erläutert. In den Zeichnungen zeigen:

Fig. 1 eine beispielsweise Ausführungsform einer erfindungsgemäßen Schaltungsanordnung; und

Fig. 2 Spannungs- und Stromverläufe, wie sie in der in Fig. 1 gezeigten Schaltungsanordnung im Normalfall und im Kurzschlußfall auftreten.

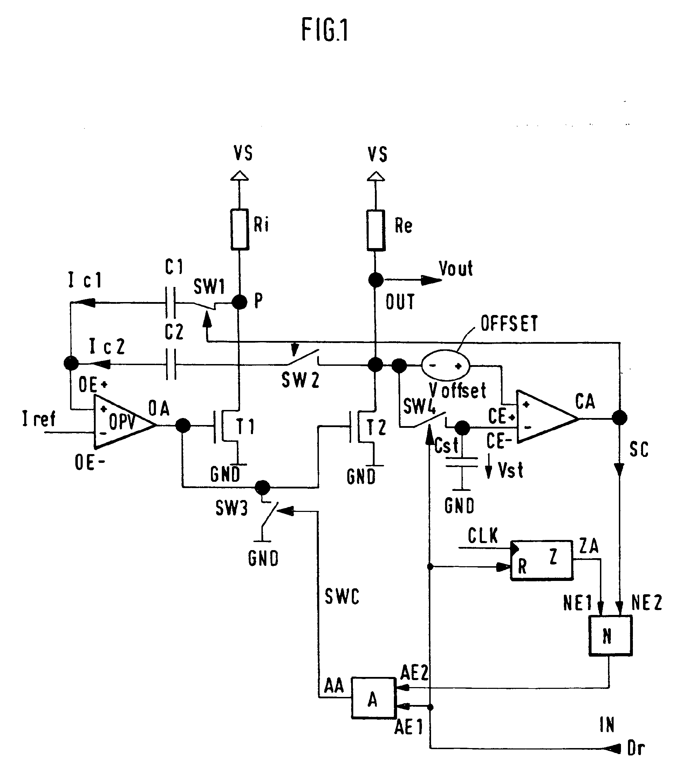

Ein Ausführungsbeispiel einer erfindungsgemäßen Schaltungsanordnung ist in Fig. 1 dargestellt. Diese Schaltungsanordnung besitzt einen Eingangsanschluß IN zur Zuführung eines Treibersignals Dr und einen Ausgangsanschluß OUT, an den eine Leitung, beispielsweise Busleitung, angeschlossen ist und an dem eine Ausgangsspannung Vout abnehmbar ist.

Diese Schaltungsanordnung umfaßt eine Regelschaltung mit zwei Regelkreisen, eine Detektorschaltung und eine Timerschaltung.

Ein erster Regelkreis umfaßt einen Transistor T1, einen internen Widerstand Ri, einen ersten Kondensator C1, einen ersten Schalter SW1, einen Operationsverstärker OPV und eine Referenzstromquelle Iref. Ri und T1 bilden eine Reihenschaltung, die zwischen einen positiven Versorgungsspannungsanschluß Vs und einen Masseanschluß GND geschaltet ist, wobei sich Ri auf der Hochpotentialseite und T1 auf der Niederpotentialseite befinden.

Ein nicht invertierender erster Eingang OE+ des Operationsverstärkers OPV ist über eine Reihenschaltung mit dem ersten Kondensator C1 und dem ersten Schalter SW1 mit einem Verbindungspunkt P zwischen Ri und T1 verbunden. Die Referenzstromquelle Iref ist zwischen einen invertierenden zweiten Eingang OE- des Operationsverstärkers OPV und GND geschaltet. An einen Ausgang OA von OPV ist eine Gateelektrode des ersten Transistors T1 angeschlossen.

Der zweite Regelkreis umfaßt einen externen Widerstand Re, einen zweiten Transistor T2, einen zweiten Kondensator C2, einen zweiten Schalter SW2 und den Operationsverstärker OPV. Re und T2 bilden eine Reihenschaltung, die zwischen Vs und GND geschaltet ist, wobei der Ausgangsanschluß OUT zwischen Re und T2 liegt. OE+ ist über eine Reihenschaltung mit dem zweiten Kondensator C2 und dem zweiten Schalter SW2 mit dem Ausgangsanschluß OUT verbunden. Eine Gateelektrode von T2 ist an den Ausgang OA des Operationsverstärkers OPV angeschlossen. Die miteinander verbundenen Gateanschlüsse der beiden Transistoren T1 und T2 sind über einen dritten Schalter SW3 mit GND verbunden.

Die Detektorschaltung umfaßt einen Komparator COMP mit einem nicht invertierenden ersten Eingang CE+, einem invertierenden zweiten Eingang CE- und einem Ausgang CA. Der erste Eingang CE+ ist über eine Offsetspannungsquelle OFFSET an den Ausgangsanschluß OUT angeschlossen. Zwischen OUT und CE- befindet sich eine Abtast- und Speicherschaltung mit einem Speicherkondensator Cst und einem vierten Schalter SW4. Dabei ist SW4 zwischen OUT und CE- und Cst zwischen CE- und GND geschaltet.

Die Timerschaltung umfaßt einen Zähler Z, ein NAND-Glied N und ein UND-Glied A. Der Zähler Z besitzt einen Zähltakteingang ZLK, einen Rücksetzeingang R und einen Zählerausgang ZA. Das NAND-Glied weist einen ersten Eingang NE1, einen zweiten Eingang NE2 und einen Ausgang NA auf. Das UND-Glied besitzt einen ersten Eingang AE1, einen zweiten Eingang AE2 und einen Ausgang AA. Der Zähltakteingang ZLK ist mit einer (nicht dargestellten) Zähltaktquelle verbunden. Ein Steueranschluß des vierten Schalters SW4, der Rücksetzeingang R des Zählers Z und der erste Eingang AE1 des UND-Gliedes A sind mit Eingangsanschluß IN verbunden, so daß ihnen das Treibersignal Dr zugeführt wird.

Ein Steuereingang des ersten Schalters SW1, ein Steuereingang des zweiten Schalters SW2 und der zweite Eingang NE2 des NAND-Gliedes N sind mit dem Ausgang CA des Komparators COMP verbunden. Der zweite Eingang AE2 des UND-Gliedes A ist mit dem Ausgang NA des NAND-Gliedes N verbunden. Ein Steueranschluß des dritten Schalters SW3 ist mit dem Ausgang AA des UND-Gliedes A verbunden.

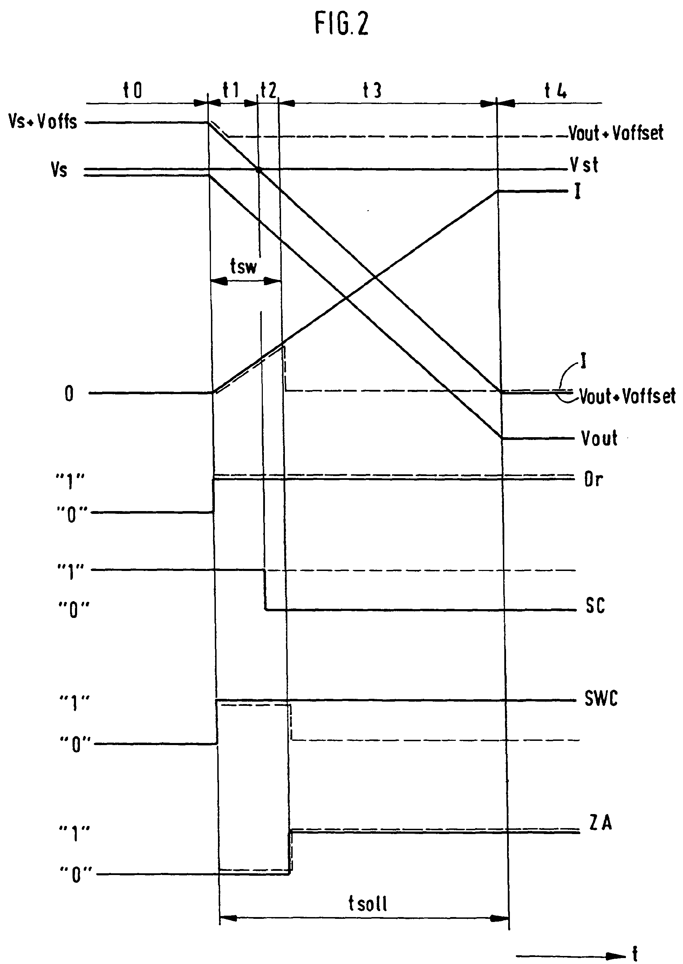

Die Funktionsweise der in Fig. 1 gezeigten Schaltungsanordnung wird nun unter Zuhilfenahme der in Fig. 2 dargestellten Spannungs- und Stromverläufe erläutert. Dabei gehören in Fig. 2 Darstellungen mit durchgezogenen Linien zum kurzschlußfreien Fall und Darstellungen mit gestrichelten Linien zum Kurzschlußfall.

Zunächst wird der Fall betrachtet, daß die Schaltungsanordnung normal arbeitet, das heißt, am Ausgangsanschluß OUT kein Kurzschluß vorhanden ist.

Die Schaltungsanordnung ist so ausgelegt, daß ein am Komparatorausgang CA auftretendes Signal SC bei Flankenbeginn immer einen Logikwert "1" aufweist. Zu einem späteren Zeitpunkt geht das Signal SC von "1" auf "0" über, wobei hier SC = "0" als das Detektionssignal für die Detektion eines kurzschlußfreien Zustandes betrachtet wird. Bei Flankenbeginn geht die Schaltungsanordnung somit sicherheitshalber immer vom Vorliegen eines Kurzschlusses aus, auch wenn sich dieser bei der nachfolgenden Überprüfung nicht bestätigt.

Mittels des dem Eingangsanschluß IN zugeführten Treibersignals Dr wird die Signalform der am Ausgangsanschluß OUT auftretenden Ausgangsspannung Vout gesteuert. Bei dem betrachteten Beispiel wird davon ausgegangen, daß mit dem Treibersignal Dr eine impulsförmige Ausgangsspannung Vout mit hinsichtlich ihrer Steilheit und damit hinsichtlich ihrer Dauer geregelten Impulsflanken gesteuert wird. Wenn die Schaltungsanordnung mittels des Treibersignals Dr in einen Ausschaltzustand gesteuert ist, befindet sich Vout praktisch auf dem Spannungswert der Versorgungsspannung Vs und ist ein am Ausgang OUT fließender Strom I praktisch gleich Null. Im Einschaltzustand liefert die Schaltungsanordnung einen von Null verschiedenen Strom I und befindet sich die Ausgangsspannung Vout praktisch auf Massepotential GND.

Bei dem betrachteten Ausführungsbeispiel wird davon ausgegangen, daß ein Treibersignal Dr mit einem niedrigen Potentialwert, der hier beispielsweise als Logikwert "0" bezeichnet wird, die Schaltungsanordnung in den ausgeschalteten Zustand steuert, während ein hoher Potentialwert, dem der Logikwert "1" zugeordnet wird, die Schaltung in den stromliefernden Einschaltzustand steuert. Dies ist auch Fig. 2 entnehmbar, in welcher fünf Zeitabschnitte t0 bis t4 dargestellt sind. Während des Zeitabschnitts t0 weist das Treibersignal Dr niedriges Potential auf und befindet sich die Ausgangsspannung Vout praktisch auf dem Spannungswert des Versorgungsspannungspotentials Vs. Während des Zeitabschnitts t0 befindet sich der vierte Schalter SW4 in leitendem Schaltzustand, so daß im Speicherkondensator Cst der Spannungswert von Vout gespeichert wird, der zu dieser Zeit praktisch Vs ist.

Die Offsetspannungsquelle OFFSET ist derart gepolt, daß am Eingang CE+ des Komparators COMP ein Spannungswert erscheint, der um Voffset höher ist als Vout. Während des Zeitabschnitts t0 befindet sich Ce+ daher auf einem Summenspannungswert von Vs+Voffset, wie dies in Fig. 2 dargestellt ist.

Wie aus Fig. 2 entnehmbar, fällt die Ausgangsspannung im Kurzschlußfall nach Flankenbeginn nur um einen relativ kleinen Betrag gegenüber dem Spannungswert vor Flankenbeginn ab. Der Betrag der Offsetspannung Voffset wird so gewählt, daß er in jedem Fall größer ist als der Betrag, um den die Ausgangsspannung Vout im Kurzschlußfall gegenüber dem Spannungswert vor Flankenbeginn abfällt.

Wenn zu Beginn des Zeitabschnittes t1 das Treibersignal Dr von "0" auf "1" übergeht, wird der vierte Schalter SW4 vom leitenden in den nichtleitenden Zustand geschaltet, so daß im Speicherkondensator Cst der vor dieser Umschaltung von Dr vorhandene Spannungswert von Vout gespeichert gehalten wird, also der Spannungswert Vs.

Während t0 hat das auf "0" befindliche Treibersignal Dr den Zähler Z über den Eingang R im Rücksetzzustand gehalten. Der Logikwert "0" am Eingang NE1 und der Logikwert "1" am Eingang NE2 des NAND-Gliedes N ergaben einen Logikwert "1" am Eingang AE2 des UND-Gliedes A, was zusammen mit dem Logikwert "0" des Treibersignals Dr zu einem Logikwert "0" am Ausgang AA des UND-Gliedes A führte, der den dritten Schalter SW3 in den leitenden Zustand steuerte. Daher befanden sich die Gateanschlüsse der Transistoren T1 und T2 auf Massepotential GND, wodurch die Schaltungsanordnung stromlos gesteuert war.

Infolge des Übergangs des Treibersignals Dr von "0" auf "1" zu Beginn des Zeitabschnitts t1 kommt es zu einem Logikwertwechsel am Ausgang AA von "0" auf "1", wodurch SW3 in den nicht-leitenden Zustand gesteuert wird.

Ein Logikwert "1" des am Komparatorausgang CA auftretenden Signals SC bedeutet, daß der Schalter SW1 und der Schalter SW2 nicht-leitend gesteuert sind, welche Schaltzustände in Fig. 1 gezeigt sind. Mit dem Öffnen von SW3 wird daher zu Beginn des Zeitabschnittes t1 der erste Regelkreis mit dem Kondensator C1 regelaktiv, während aufgrund des nicht-leitend gesteuerten Schalters SW2 der zweite Regelkreis mit dem Kondensator C2 regelinaktiv bleibt.

Mit dem nicht-leitend Steuern des Schalters SW3 beginnt somit ein ansteigender Strom durch Transistor T1 zu fließen, der auf Übereinstimmung mit dem Referenzstrom Iref geregelt wird. Dieser Strom entspricht einer Soll-Steilheit der mit Beginn des Zeitraums t1 beginnenden Flanke. Da das Ausgangssignal des Operationsverstärkers OPV nicht nur dem Gateanschluß des Transistors T1 sondern auch dem Gateanschluß des Transistors T2 zugeführt wird, wird der durch T2 fließende Strom in Abhängigkeit von dem Regelergebnis des ersten Regelkreises gesteuert. Das heißt, mit Beginn des Zeitraums t1 wird die Steilheit der am Ausgangsanschluß OUT auftretenden Flanke der Ausgangsspannung Vout in Abhängigkeit von dem Regelergebnis des ersten Regelkreises und damit in Abhängigkeit von der an Ri auftretenden Spannungsabfalländerung gesteuert. Mit der flankengemäßen Abnahme der Ausgangsspannung Vout nimmt auch der Betrag der Summenspannung Vout+Voffset am Eingang CE+ des Komparators COMP ab, die mit dem im Speicherkondensator Cst gespeicherten Spannungswert Vst, also dem vor Flankenbeginn vorliegenden Spannungswert von Vout, somit praktisch Vs, verglichen wird. Solange die an C+ anliegende Summenspannung noch höher ist als die an CE- anliegende Speicherspannung Vst, bleibt das Signal SC auf dem Logikwert "1" und bleiben die Schalter SW1 und SW2 in den in Fig. 1 gezeigten Schaltzuständen, so daß der erste Regelkreis regelaktiv und der zweite Regelkreis regelinaktiv bleiben.

Sobald die Summenspannung Vout+Voffset den in Cst gespeicherten Spannungswert Vst unterschreitet, schaltet der Ausgang CA des Komparators COMP und damit das Signal SC von "1" auf "0" um. Der Komparatorausgang liefert also das Detektionssignal SC = "0", welches einen kurzschlußfreien Betrieb detektiert. Dies findet zu Beginn des Zeitabschnitts t2 statt. Als Folge davon werden SW1 in den nichtleitenden und SW2 in den leitenden Zustand gesteuert, wodurch der erste Regelkreis mit dem Kondensator C1 regelinaktiv und der zweite Regelkreis mit dem Kondensator C2 regelaktiv geschaltet werden. Daher wird ab dem Beginn von t2 nicht mehr der Kondensatorstrom Ic1 sondern der Kondensatorstrom Ic2 auf den Referenzstrom Iref geregelt. Die Ausgangsspannung Vout wird von diesem Zeitpunkt an nicht mehr in Abhängigkeit vom ersten Regelkreis gesteuert sondern über den zweiten Regelkreis geregelt.

Bei der Darstellung in Fig. 2 wird davon ausgegangen, daß die Flankensteilheit beim Übergang vom Zeitabschnitt t1 auf den Zeitabschnitt t2 unverändert bleibt. Dies kann man dadurch erreichen, daß die Ströme durch die Reihenschaltungen Ri, T1 einerseits und Re, T2 andererseits gleich groß gemacht werden. Um zu einer niedrigen Verlustleistung im ersten Regelkreis zu kommen, die vom Chip der die erfindungsgemäße Schaltungsanordnung enthaltenden integrierten Schaltung geliefert werden muß, macht man den Widerstandswert von Ri vorzugsweise viel größer als den am Ausgangsanschluß OUT wirksamen Widerstandswert. Um trotzdem eine Stromspiegelung von 1:1 zu erhalten, werden die aktiven Flächen der Transistoren T1 und T2 entsprechend unterschiedlich gemacht.

Damit bei unterschiedlichen Widerstandswerten für Ri und Re (dem an OUT wirkenden Widerstand) ein gleiches dU/dt, also eine gleiche Steilheit zustandekommt, wird für T1 eine größere und für T2 eine kleinere aktive Fläche gewählt, und zwar entsprechend dem Verhältnis zwischen dem internen Widerstand Ri und dem an OUT wirkenden Widerstand Re. Dem Widerstand mit dem größeren Widerstandswert wird also ein Transistor mit größerer aktiver Fläche und dem Widerstand mit dem kleineren Widerstandswert wird ein Transistor mit einer kleineren aktiven Fläche zugeordnet.

Mit Hilfe der Timerschaltung wird überprüft, ob am Ende des Zeitabschnitts t2, was einer Zeitdauer tsw seit Flankenbeginn entspricht, die Summenspannung am Eingang CE+ unter die gespeicherte Spannung CE- abgesunken ist oder nicht. Dies wird dadurch erreicht, daß deren Zähler Z mit dem Logikwertwechsel des Treibersignals Dr am Flankenbeginn vom Rücksetzzustand in einen Zählbeginnzustand umgeschaltet wird. Mit Beginn des Zeitabschnitts tsw beginnt der Zähler Z daher die ihm zugeführten Taktimpulse zu zählen. Beim Erreichen eines vorbestimmten Zählstandes, welcher der Zeitdauer tsw entspricht, schaltet der Ausgang ZA des Zählers Z von "0" auf "1" um, wie es in Fig. 2 gezeigt ist. Da zu Beginn von t2 die Summenspannung an CE+ bereits unter den gespeicherten Spannungswert an CE- abgefallen war und SC auf den Logikwert "0" übergegangen war, bleibt am Ausgang von N der Logikwert "1", so daß der dritte Schalter SW3 weiterhin nicht-leitend gesteuert bleibt und der Regelvorgang mittels des zweiten Regelkreises weiterläuft. Die abfallende Flanke von Vout bzw. die ansteigende Flanke von 1 stetzen sich somit im Zeitabschnitt t3 fort, bis die Regelschaltung den Transistor T2 maximal leitend gesteuert hat und die Ausgangsspannung Vout und der durch T2 fließende Strom I von da ab konstant bleiben, wie es im Zeitabschnitt t4 in Fig. 2 dagestellt ist.

Es wird nun der Fall, daß am Ausganganschluß OUT ein Kurzschluß vorliegt, welcher den externen Widerstand Re überbrückt, näher betrachtet. Wenn zum Zeitpunkt des Umschaltens von Dr von "0" auf "1" zu Beginn des Zeitabschnittes t1 ein Kurzschluß vorliegt, nimmt die Ausgangsspannung Vout zunächst etwas ab, weil interne Widerstände und externe Leitungswiderstände zu einem von 0 verschiedenen Widerstandswert führen, an dem ein gewisser Spannungsabfall auftritt. Dies führt dazu, daß zunächst ein Stromanstieg auftritt und ein entsprechender Spannungsabfall an dem im Kurzschlußfall wirkenden Widerstandswert. Da während des Zeitabschnittes t1 der vom Transistor T2 gelieferte Strom in Abhängigkeit von dem ersten Regelkreis, nämlich in Abhängigkeit von Ri gesteuert wird, tritt bei Flankenbeginn kein sehr stark zunehmender Kurzschlußstrom auf, sondern eine Stromzunahme, wie sie zu diesem Zeitpunkt auch bei kurzschlußfreiem Betrieb aufträte. Dadurch, daß während des Flankenbeginns der Strom durch t2 keiner Regelung unterliegt, sondern einer Steuerung durch den ersten Regelkreis, ist also ein Anstieg auf einen sehr hohen Kurzschlußstrom unterbunden.

Im Kurzschlußfall sinkt aber die Ausgangsspannung Vout nur auf einen relativ Meinen Wert unterhalb der Versorgungsspannung Vs ab. Ein Absinken der Summenspannung Vout+Voffset unter den in Cst gespeicherten Spannungswert Vs der Ausgangsspannung vor Flankenbeginn wird daher nicht erreicht, wenn der Zähler Z am Ende der Zeitdauer tsw ab Flankenbeginn seinen vorbestimmten Zählwert erreicht hat und sein Ausgang ZA von "0" auf "1" übergeht. Das Signal SC = "1" ist daher nach Ablauf von tsw immer noch vorhanden, das Detektionssignal SC = "0" also nicht aufgetreten, was zu einem Logikwert "0" am Ausgang NA des NAND-Gliedes N führt. Zusammen mit dem Logikwert "1" von Dr am Eingang AE2 des UND-Gliedes A kommt es daher an dessen Ausgang AA zu einem Wechsel des Schaltersteuersignals SWC von "1" nach "0" Dadurch wird der dritte Schalter SW3 am Ende des Zeitabschnitts tsw in den leitenden Zustand gesteuert, wodurch die Transistoren T1 und T2 in den Sperrzustand gebracht werden. Der zum Ausgang OUT fließende Strom I hört somit auf und die Schaltungsanordnung wird praktisch stromlos.

Dadurch, daß der Strom I auch im Kurzschlußfall bei Flankenbeginn der vom internen Widerstand Ri abhängigen Steuerung durch den ersten Regelkreis unterliegt, wird auch im Kurzschlußfall während des Flankenbeginns eine Flankensteilheit der vorbestimmten Art gesteuert und eine elektromagnetische Störabstrahlung aufgrund zu hoher Flankensteilheit vermieden. Da der Strom I im Kurzschlußfall schon in einem sehr frühen und niedrigen Stadium abgeschaltet wird, nämlich am Ende von tsw, kann es nicht zu einem hohen Stromfluß im Kurzschlußfall kommen, und daher auch nicht zur Speicherung hoher magnetischer Energie in Lastinduktivitäten. Hohe induktive Spannungsspitzen zum Zeitpunkt der Schutzabschaltung aufgrund eines Kurzschlusses können daher nicht auftreten und folglich auch keine damit verbundenen elektromagnetischen Störstrahlungen und/oder Signalfehlinterpretationen.

Zusammengefaßt wird dies dadurch erreicht, daß man erfindungsgemäß dem zweiten Regelkreis während einer Beginnphase der Flanke die Regelhobheit entzieht und das Geschehen am Ausganganschluß OUT einer Zwangssteuerung durch den ersten Regelkreis unterwirft; daß man während dieser Zwangssteuerung unabhängig davon, ob ein Kurzschluß vorhanden ist oder nicht, die Flanke auf die vorbestimmte Steilheit steuert; daß man beobachtet, ob sich die Ausgangsspannung innerhalb einer bestimmten Zeitspanne tsw soweit gegenüber dem vor Flankenbeginn herrschenden Spannungswert geändert hat, wie es nur im kurzschlußfreien Fall passieren kann; und daß man dann, wenne ein solche Änderung bis zum Ende dieser Zeitspanne nicht erreicht ist, die Schaltungsanordnung stromlos schaltet. Dieses Abschalten erfolgt relativ kurze Zeit nach dem Flankenbeginn und bevor der Kurzschluß zu einem hohen Kurzschlußstrom mit den genannten Problemen führen kann.

Eine erfindungsgemäße Schaltungsanordnung kann im Zusammenhang mit Busleitungen verwendet werden, aber auch in allen anderen Fällen, in denen eine Flankensteilheitsregelung gewünscht ist.

**Patentansprüche**

1. Elektrische Schaltungsanordnung zur Formung der Flankensteilheit einer an einem Ausgangsanschluß (OUT) auftretenden impulsförmigen Ausgangsspannung (Vout) und zur Erkennung eines Kurzschlusses an dem Ausgangsanschluß (OUT), aufweisend:

   a) eine umschaltbare Regelschaltung (C1, C2, T1, T2, OPV, SW1, SW2, SW4), mittels welcher die Flankensteilheit der Ausgangsspannung (Vout) in einem ersten Schaltzustand in Abhängigkeit von einem an einer internen elektrischen Vorrichtung (Ri) generierten Spannungsverlauf gesteuert wird und in einem zweiten Schaltzustand die Flankensteilheit der Ausgansspannung (Vout) gemäß einem vorbestimmten Verlauf geregelt wird und die sich in einem dritten Schaltzustand in einem im wesentlichen stromlosen Zustand befindet;
   b) eine Detektorschaltung (COMP, Cst, OFFSET), die ein Detektionssignal (SC) liefert, wenn die Ausgangsspannung (Vout) um mindestens einen vorbestimmten Wert von dem vor Flankenbeginn auftretenden Ausgangsspannungswert abweicht; und
   c) eine Timerschaltung (Z, N, A), mittels welcher die Regelschaltung eine vorbestimmte Zeitdauer (tsw) nach Flankenbeginn vom ersten in den zweiten Schaltzustand umgeschaltet wird, wenn zu diesem Zeitpunkt das Detektionssignal (SC = "0") vorliegt, und vom ersten in den dritten Schaltzustand umgeschaltet wird, wenn zu diesem Zeitpunkt das Detektionssignal nicht vorliegt (SC = "1").

2. Schaltungsanordnung nach Anspruch 1, bei welcher die Regelschaltung aufweist:

   a) einen ersten Regelkreis (C1, OPV, T1, Ri), mittels welchem die Flankensteilheit der Ausgangsspannung (Vout) in Abhängigkeit von dem an einem internen Widerstand generierten Spannungsverlauf gesteuert wird ;
   b) einen zweiten Regelkreis (C2, OPV, T2, Re), mittels welchem die Flankensteilheit der Ausgangsspannung (Vout) gemäß dem vorbestimmten Verlauf geregelt wird ; und
   c) eine mittels des Detektionssignals (SC) steuerbare erste Umschalteinrichtung (SW1, SW2) mittels welcher in Abhängigkeit davon, ob das Detektionssignal nicht vorliegt (SC = "1") oder vorliegt (SC = "0"), im ersten Schaltzustand der Regelschaltung der erste Regelkreis regelaktiv und der zweite Regelkreis regelinaktiv beziehungsweise im zweiten Schaltzustand der Regelschaltung der zweite Regelkreis regelaktiv und der erste Regelkreis regelinaktiv geschaltet werden.

**3.** Schaltungsanordnung nach Anspruch 2, bei welcher die Regelschaltung aufweist:

eine mittels der Timerschaltung (Z, N, A) steuerbare zweite Umschalteinrichtung (SW3), mittels welcher beide Regelkreise im dritten Schaltzustand der Regelschaltung stromlos geschaltet werden, wenn bei Ablauf der vorbestimmten Zeitdauer (tsw) nach Flankenbeginn das Detektionssignal nicht vorliegt.

**4.** Schaltungsanordnung nach Anspruch 2 oder 3,

a) bei welcher der erste Regelkreis aufweist:

- **eine zwischen zwei 1 unterschiedliche** Versorgungsspannungsanschlüsse (Vs, GND) geschaltete erste Reihenschaltung mit einem ersten Transistor (T1) und dem internen Widerstand (Ri),
- einen ersten Kondensator (C1), von dem eine Seite an einen Verbindungspunkt (P) zwischen erstem Transistor (T1) und internen Widerstand (Ri) angeschlossen ist,
- und einen Differenzverstärker (OPV) mit einem ersten Verstärkereingang (OE-), der mit einer zweiten Seite des ersten Kondensators (C1) gekoppelt ist, mit einem zweiten Verstärkereingang (OE-), der mit einer Referenzstromquelle (Iref) gekoppelt ist und einem Verstärkerausgang (OA); und

b) bei welcher der zweite Regelkreis aufweist:

- eine zwischen die beiden Versorgungsspannungsanschlüsse (Vs, GND) geschaltete zweite Reihenschaltung mit einem zweiten Transistor (T2) und einem externen Widerstand (Re)
- und einen zweiten Kondensator (C2), der zwischen den Ausgangsanschluß (OUT) und den ersten Verstärkereingang (OE+) geschaltet ist;

c) wobei die beiden Transistoren (T1, T2) je einen mit dem Verstärkerausgang (OA) gekoppelten Steuereingang aufweisen.

**5.** Schaltungsanordnung nach Anspruch 4, bei welcher die erste Umschalteinrichtung einen zwischen den Verbindungspunkt (P) und den ersten Kondensator (C1) geschalteten ersten Schalter (SW1) und einen zwischen den Ausgangsanschluß (OUT) und den zweiten Kondensator (C2) geschalteten zweiten Schalter (SW2) aufweist.

**6.** Schaltungsanordnung nach Anspruch 4 oder 5, bei welcher die zweite Umschalteinrichtung einen dritten Schalter (SW3) aufweist, der zwischen die Steuereingänge der beiden Transistoren (T1, T2) und denjenigen der beiden Versorgungsspannungsanschlüsse (GND), dessen Potential die beiden Transistoren (T1, T2) in einen Sperrzustand steuert, geschaltet ist.

**7.** Schaltungsanordnung nach einem der Ansprüche 1 bis 6, bei welcher die Detektorschaltung aufweist:

a) einen Komparator (COMP) mit einem nichtinvertierenden Komparatoreingang (CE+), einem invertierenden Komparatoreingang (CE-) und einem Komparatorausgang (CA);
b) eine zwischen den nichtinvertierenden Komparatoreingang (CE+) und den Ausgangsanschluß (OUT) geschaltete Offsetspannungsquelle (OFFSET), aufgrund welcher am nichtinvertierenden Komparatoreingang (CE+) eine Summenspannung gleich der Summe aus Ausgangsspannung (Vout) und Offsetspannung (Voffset) auftritt; und
c) eine Abtast- und Speicherschaltung (Cst, SW4), mittels welcher die vor Flankenbeginn auftretende Ausgangsspannung (Vout) abtastbar und speicherbar ist;
d) wobei am Komparatorausgang (CA) das Detektionssignal (SC = "0") entsteht, wenn die Summenspannung (Vout+Voffset) von dem in der Abtast- und Speicherschaltung (Cst, SW4) gespeicherten Spannungswert (Vs) um den vorbestimmten Wert abweicht.

**8.** Schaltungsanordnung nach Anspruch 7, bei welcher die Abtast- und Speicherschaltung (Cst, SW4) einen zwischen den Ausgangsanschluß (OUT) und den invertierenden Komparatoreingang (CE-) geschalteten vierten Schalter (SW4) aufweist und einen Speicherkondensator (Cst), der zwischen den invertierenden Komparatoreingang (CE-) und denjenigen (GND) der beiden Versorgungsspannungsanschlüsse, dessen Potential die beiden Transistoren (T1, T2) in den Sperrzustand steuert, wenn es deren Steuerelektroden zugeführt wird, wobei der vierte Schalter (SW4) vor Flankenbeginn leitend gesteuert ist und bei Flankenbeginn nichtleitend gesteuert wird.

9. Schaltungsanordnung nach einem der Ansprüche 1 bis 8, bei welchem die Timerschaltung (Z, N, A) aufweist:

a) eine Impulssteuersignalquelle (Dr);
b) einen Zähler (Z) mit einem Takteingang (CLK), einem mit der Impulssteuersignalquelle (Dr) verbundenen Rücksetzeingang (R) und einen Zählerausgang (ZA);
c) eine NAND-Verknüpfungsschaltung (N) mit einem mit dem Zählerausgang (ZA) gekoppelten ersten Eingang (NE1), einem mit dem Komparatorausgang (CA) der Detektionsschaltung gekoppelten zweiten Eingang (NE2) und einem Ausgang (NA);
d) und eine UND- Verknüpfungsschaltung (A) mit einem ersten Eingang (AE1), der mit dem Ausgang (NA) der NAND-Verknüpfungsschaltung (N) gekoppelt ist, einem zweiten Eingang (AE1), der mit der Impulssteuersignalquelle (Dr) gekoppelt ist, und einen Ausgang (AA), der ein Schaltsteuersignal (SWc) für den dritten Schalter (SW3) liefert; wobei:
e) der Zähler (Z) an seinem Zählerausgang (ZA) ein Zeitablaufsignal (tws) abgibt, wenn er einen vorbestimmten Zählstand erreicht hat;
f) der vierte Schalter (SW4) von der Impulssteuersignalquelle (Dr) steuerbar ist; und
g) die Timerschaltung den dritten Schalter (SW3) dann leitend steuert, wenn nach Ablauf der vorbestimmten Zeitdauer (tws) ab Flankenbeginn das Detektionssignal (SC = "0") noch nicht vorliegt.

10. Schaltungsanordnung nach einem der Ansprüche 4 bis 9, bei welcher der interne Widerstand (Ri) einen höheren Widerstandswert aufweist als der am Ausgangsanschluß (OUT) wirksame Widerstandswert (Re) und der erste Transistor (T1) eine höhere aktive Transistorfläche aufweist als der zweite Transistor (T2), derart, daß die vom ersten Regelkreis gesteuerte Flankensteilheit mit der vom zweiten Regelkreis geregelten Flankensteilheit mindestens in etwa übereinstimmt.

**Claims**

1. An electric circuit arrangement for shaping the slew rate of a pulsed output voltage (Vout) occurring at an output terminal (OUT) and for detecting a short circuit at the output terminal (OUT), comprising:

a) a switchover control circuit (C1, C2, T1, T2, OPV, SW1, SW2, SW4) which controls the slew rate of the output voltage (Vout) as a function of a voltage curve generated on an internal electric device (Ri) in a first switching state, and feedback-controls the slew rate of the output voltage (Vout) as a function of a predetermined curve in a second switching state, and which is in a substantially dead state in a third switching state;
b) a detector circuit (COMP, Cst, OFFSET) which provides a detection signal (SC) when the output voltage (Vout) differs by a least a predetermined value from the output voltage value occurring before edge onset; and
c) a timer circuit (Z, N, A) which switches the control circuit from the first to the second switching state a predetermined length of time (tsw) after edge onset if the detection signal (SC = "0") is present at this time, and from the first to the third switching state if the detection signal is not present at this time (SC = "1").

2. A circuit arrangement according to claim 1, wherein the control circuit comprises:

a) a first control loop (C1, OPV, T1, Ri) which controls the slew rate of the output voltage (Vout) as a function of the voltage curve generated at an internal resistor;
b) a second control loop (C2, OPV, T2, Re) which feedback-controls the slew rate of the output voltage (Vout) as a function of the predetermined curve; and
c) a first switchover means (SW1, SW2) adapted to be controlled by the detection signal (SC) for making the first control loop active and the second control loop inactive in the first switching state of the control circuit, or the second control loop active and the first control loop inactive in the second switching state of the control circuit, as a function of whether the detection signal is not present (SC = "1") or is present (SC = "0").

3. A circuit arrangement according to claim 2, wherein the control circuit comprises:

a second switchover means (SW3) adapted to be controlled by the timer circuit (Z, N, A) and switching both control loops dead in the third switching state of the control circuit if the detection signal is not present at the end of the predetermined length of time (tsw) after edge onset.

4. A circuit arrangement according to claim 2 or 3,

a) wherein the first control loop comprises:

- a first series connection having a first transistor (T1) and the internal resistor (Ri) connected between two different supply voltage terminals (Vs, GND),
- a first capacitor (C1) one side of which is connected to a connecting point (P) between first transistor (T1) and internal resistor (Ri),
- and a differential amplifier (OPV) having a first amplifier input (OE-) coupled with a second side of the first capacitor (C1), and having a second amplifier input (OE-) coupled with a reference current source (Iref), and having an amplifier output (OA);

b) wherein the second control loop comprises:

- a second series connection having a second transistor (T2) and an external resistor (Re) connected between the two supply voltage terminals (Vs, GND),
- and a second capacitor (C2) connected between the output terminal (OUT) and the first amplifier input (OE+);

c) wherein the two transistors (T1, T2) ech have a control input coupled with the amplifier output (OA).

5. A circuit arrangement according to claim 4,
wherein the first switchover means has a first switch (SW1) connected between the connecting point (P) and the first capacitor (C1), and a second switch (SW2) connected between the output terminal (OUT) and the second capacitor (C2).

6. A circuit arrangement according to claim 4 or 5,
wherein the second switchover means has a third switch (SW3) connected between the control inputs of the two transistors (T1, T2) and that one of the two supply voltage terminals (GND) whose potential drives the two transistors (T1, T2) to an off state.

7. A circuit arrangement according to any of claims 1 to 6,
wherein the detector circuit comprises:

a) a comparator (COMP) having a non-inverting comparator input (CE+), an inverting comparator input (CE-) and a comparator output (CA);
b) an offset voltage source (OFFSET) connected between the non-inverting comparator input (CE+) and the output terminal (OUT) and due to which a sum voltage equal to the sum of output voltage (Vout) and offset voltage (Voffset) occurs at the non-inverting comparator input (CE+); and
c) a sampling and storage circuit (Cst, SW4) for sampling and storing the output voltage (Vout) occurring before edge onset;
d) wherein the detection signal (SC = "0") arises at the comparator output (CA) when the sum voltage (Vout+Voffset) differs by the predetermined value from the voltage value (Vs) stored in the sampling and storage circuit (Cst, SW4).

8. A circuit arrangement according to claim 7,
wherein the sampling and storage circuit (Cst, SW4) has a fourth switch (SW4) connected between the output terminal (OUT) and the inverting comparator input (CE-), as well as a storage capacitor (Cst) between the inverting comparator input (CE-) and that one (GND) of the two supply voltage terminals whose potential drives the two transistors (T1, T2) to the off state when it is supplied to their control electrodes, the fourth switch (SW4) being rendered conductive before edge onset and rendered nonconductive upon edge onset.

9. A circuit arrangement according to any of claims 1 to 8,
wherein the timer circuit (Z, N, A) comprises:

a) a pulse control signal source (Dr);
b) a counter (Z) having a clock input (CLK), a reset input (R) connected to the pulse control signal source (Dr), and a counter output (ZA);
c) a NAND operation circuit (N) having a first input (NE1) coupled with the counter output (ZA), a second input (NE2) coupled with the comparator output (CA) of the detection circuit, and an output (NA);

d) and an AND operation circuit (A) having a first input (AE1) coupled with the output (NA) of the NAND operation circuit (N), a second input (AE1) coupled with the pulse control signal source (Dr), and an output (AA) which provides a switch control signal (SWc) for the third switch (SW3);
wherein:
e) the counter (Z) provides a time lapse signal (tsw) at its counter output (ZA) when it has reached a predetermined count;
f) the fourth switch (SW4) is adapted to be controlled by the pulse control signal source (Dr); and
g) the timer circuit renders the third switch (SW3) conductive when the detection signal (SC = "0") is not yet present at the end of the predetermined length of time (tsw) from edge onset.

10. A circuit arrangement according to any of claims 4 to 9,
wherein the internal resistor (Ri) has a higher resistance than the resistance (Re) effective at the output terminal (OUT), and the first transistor (TR1) has a higher active transistor area than the second transistor (T2), such that the slew rate controlled by the first control loop at least roughly matches the slew rate feedback-controlled by the second control loop.

**Revendications**

1. Système de circuits électriques pour former la pente de signal d'une tension de sortie pulsée (Vout) apparaissant à une borne de sortie (OUT) et pour identifier un court-circuit à la borne de sortie (OUT), comprenant :

a) un circuit de régulation commutable (C1, C2, T1, T2, OPV, SW1, SW2, SW4), au moyen duquel la pente de signal de la tension de sortie (Vout) dans un premier état de commutation est commandée en fonction d'une courbe de tension générée au niveau d'un dispositif électrique interne (Ri), et dans un deuxième état de commutation, la pente de signal de la tension de sortie (Vout) est régulée selon une courbe prédéterminée, et qui se trouve dans un troisième état de commutation dans un état substantiellement hors tension ;
b) un circuit détecteur (COMP, Cst, OFFSET) qui fournit un signal de détection (SC) quand la tension de sortie (Vout) s'écarte au moins d'une valeur prédéterminée de la valeur de tension de sortie apparaissant avant le début de la pente ; et
c) un circuit temporisateur (Z, N, A) au moyen duquel le circuit de régulation est commuté pendant une durée prédéterminée (tsw) après le début de la pente du premier au deuxième état de commutation si à ce moment le signal de détection est présent (SC = "0"), et est commuté du premier au troisième état de commutation si à ce moment le signal de détection n'est pas présent (SC = " 1 ").

2. Système de circuits selon la revendication 1, dans lequel le circuit de régulation présente :

a) une première boucle de régulation (C1, OPV, T1, Ri) au moyen de laquelle la pente de signal de la tension de sortie (Vout) est commandée en fonction de la courbe de tension générée au niveau d'une résistance interne ;
b) une deuxième boucle de régulation (C2, OPV, T2, Re) au moyen de laquelle la pente de signal de la tension de sortie (Vout) est régulée selon la courbe prédéterminée ; et
c) un premier dispositif de commutation (SW1, SW2), pouvant être commandé au moyen du signal de détection (SC), au moyen duquel, en fonction du fait que le signal de détection est absent (SC = "1") ou présent (SC = "0"), dans le premier état de commutation du circuit de régulation, la première boucle de régulation est commutée pour être active pour la régulation, et la deuxième boucle de régulation est commutée pour être inactive pour la régulation, ou bien dans le deuxième état de commutation du circuit de régulation, la deuxième boucle de régulation est commutée pour être active pour la régulation et la première boucle de régulation est commutée pour être inactive pour la régulation.

3. Système de circuits selon la revendication 2, dans lequel le circuit de régulation présente :

un deuxième dispositif de commutation (SW3) pouvant être commandé au moyen du circuit temporisateur (Z, N, A), au moyen duquel, dans le troisième état de commutation du circuit de régulation, les deux boucles de régulation sont commutées hors tension si après expiration de la durée prédéterminée (tsw) après le début de la pente, le signal de détection n'est pas présent.

4. Système de circuits selon la revendication 2 ou 3,

a) dans lequel la première boucle de régulation présente :

- un premier montage en série connecté entre deux bornes de tension d'alimentation différentes (Vs, GND) avec un premier transistor (T1) et la résistance interne (Ri),
- un premier condensateur (C1) dont un côté est connecté à un point de jonction (P) entre le premier transistor (T1) et la résistance interne (Ri),
- et un amplificateur différentiel (OPV) avec une première entrée d'amplificateur (OE-) qui est couplée avec un deuxième côté du premier condensateur (C1), avec une deuxième entrée d'amplificateur (OE-) qui est couplée avec une source de courant de référence (Iref) et une sortie d'amplificateur (OA) ; et

b) dans lequel la deuxième boucle de régulation présente :

- un deuxième montage en série connecté entre les deux bornes de tension d'alimentation (Vs, GND) avec un deuxième transistor (T2) et une résistance externe (Re)
- et un deuxième condensateur (C2) qui est connecté entre la borne de sortie (OUT) et la première entrée d'amplificateur (OE+) ;

c) dans lequel les deux transistors (T1, T2) présentent respectivement une entrée de commande couplée avec la sortie d'amplificateur (OA).

5. Système de circuits selon la revendication 4, dans lequel le premier dispositif de commutation présente un premier commutateur (SW1) connecté entre le point de jonction (P) et le premier condensateur (C1) et un deuxième commutateur (SW2) connecté entre la borne de sortie (OUT) et le deuxième condensateur (C2).

6. Système de circuits selon la revendication 4 ou 5, dans lequel le deuxième dispositif de commutation présente un troisième commutateur (SW3) qui est connecté entre les entrées de commande des deux transistors (T1, T2) et celles des deux bornes de tension d'alimentation (GND) dont le potentiel commande les deux transistors (T1, T2) dans un état de blocage.

7. Système de circuits selon l'une quelconque des revendications 1 à 6, dans lequel le circuit détecteur présente :

a) un comparateur (COMP) avec une entrée de comparateur non inverseuse (CE+), une entrée de comparateur inverseuse (CE-) et une sortie de comparateur (CA) ;
b) une source de tension de décalage (OFFSET) connectée entre l'entrée de comparateur non inverseuse (CE+) et la borne de sortie (OUT) et en raison de laquelle une tension totale égale à la somme de la tension de sortie (Vout) et de la tension de décalage (Voffset) se présente à l'entrée de comparateur non inverseuse (CE+) ; et
c) un circuit de balayage et de stockage (Cst, SW4), au moyen duquel la tension de sortie (Vout) apparaissant avant le début de la pente peut être balayée et stockée ;
d) dans lequel à la sortie de comparateur (CA), le signal de détection (SC = "0") apparaît quand la tension totale (Vout + Voffset) s'écarte de la valeur prédéterminée de la valeur de tension (Vs) stockée dans le circuit de balayage et de stockage (Cst, SW4).

8. Système de circuits selon la revendication 7, dans lequel le circuit de balayage et de stockage (Cst, SW4) présente un quatrième commutateur (SW4) connecté entre la borne de sortie (OUT) et l'entrée de comparateur inverseuse (CE-) et commande un condensateur de puissance (Cst) entre l'entrée de comparateur inverseuse (CE-) et celle (GND) des deux bornes de tension d'alimentation dont le potentiel commande les deux transistors (T1, T2) dans l'état de blocage lorsqu'il est amené à leurs électrodes de commande, dans lequel le quatrième commutateur (SW4) est commandé pour être conducteur avant le début de la pente et commandé pour être non-conducteur au début de la pente.

9. Système de circuits selon l'une quelconque des revendications 1 à 8, dans lequel le circuit temporisateur (Z, N, A) présente :

a) une source de signal de commande par impulsion (Dr) ;
b) un compteur (Z) avec une entrée d'horloge (CLK), une entrée de réinitialisation (R) reliée à la source de signal de commande par impulsion (Dr) et une sortie de compteur (ZA) ;
c) un circuit combinatoire NON-ET (N) avec une première entrée (NE1) couplée avec la sortie de compteur (ZA), une deuxième entrée (NE2) couplée avec la sortie de comparateur (CA) du circuit de détection et une sortie (NA) ;

d) et un circuit combinatoire ET (A) avec une première entrée (AE1) qui est couplée avec la sortie (NA) du circuit combinatoire NON-ET (N), une deuxième entrée (AE1) qui est couplée avec la source de signal de commande par impulsion (Dr) et une sortie (AA) qui fournit un signal de commande de commutation (SWc) pour le troisième commutateur (SW3) ; dans lequel

e) le compteur (Z) délivre à sa sortie de compteur (ZA) un signal d'expiration (tws) lorsqu'il a atteint une position de compteur prédéterminée ;

f) le quatrième commutateur (SW4) peut être commandé par la source de signal de commande par impulsion (Dr) ; et

g) le circuit temporisateur commande alors le troisième commutateur (SW3) pour qu'il soit conducteur lorsque après expiration de la durée prédéterminée (tws) depuis le début de la pente, le signal de détection (SC = "0") n'est toujours pas présent.

10. Système de circuits selon l'une quelconque des revendications 4 à 9, dans lequel la résistance interne (Ri) présente une valeur de résistance supérieure à la valeur de résistance (Re) effective à la borne de sortie (OUT) et le premier transistor (T1) présente une plus grande surface de transistor active que le deuxième transistor (T2), de telle sorte que la pente de signal, commandée par la première boucle de régulation, coïncide au moins approximativement avec la pente de signal régulée par la deuxième boucle de régulation.

# FIG.1

# FIG.2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3889159 A